Europäisches Patentamt

European Patent Office

Office européen des brevets

(11) Numéro de publication: **0 290 083**
**A1**

## (12) DEMANDE DE BREVET EUROPEEN

(21) Numéro de dépôt: **88200815.4**

(51) Int. Cl.⁴: **H05K 7/14**

(22) Date de dépôt: **27.04.88**

(30) Priorité: **06.05.87 FR 8706394**

(43) Date de publication de la demande:
**09.11.88 Bulletin 88/45**

(84) Etats contractants désignés:
**BE DE FR GB NL SE**

(71) Demandeur: **TELECOMMUNICATIONS RADIOELECTRIQUES ET TELEPHONIQUES T.R.T.**
**88, rue Brillat Savarin**
**F-75013 Paris(FR)**

(84) **FR**

(71) Demandeur: **N.V. Philips' Gloeilampenfabrieken**
**Groenewoudseweg 1**
**NL-5621 BA Eindhoven(NL)**

(84) **BE DE GB NL SE**

(72) Inventeur: **Delpech, Guy Société Civile S.P.I.D.**
**209, rue de l'Université**
**F-75007 Paris(FR)**
Inventeur: **Garnier, Gilles Société Civile S.P.I.D.**
**209, rue de l'Université**
**F-75007 Paris(FR)**

(74) Mandataire: **Chaffraix, Jean et al**
**Société Civile S.P.I.D. 209, rue de l'Université**
**F-75007 Paris(FR)**

(54) **Support pour plaques de circuits imprimés.**

(57) Support pour plaques de circuits imprimés formé d'une colonne (1) comprenant au moins une embase (3) sur laquelle vient en appui une plaque (6) de circuits, un collet (4) qui s'insère dans un trou (5) de la plaque, un organe d'accouplement, un amortisseur (7) étant inséré entre l'embase (3) et la plaque (6) de circuits, la compression dudit amortisseur étant assurée par l'organe d'accouplement.

FIG. 1

## Support pour plaques de circuits imprimés

L'invention concerne un support pour plaques de circuits imprimés formé d'une colonne comprenant au moins une embase, sur laquelle vient en appui une plaque de circuits, un collet qui s'insère dans un trou de la plaque, et un organe d'accouplement.

Un tel support est connu entre autre du brevet français 2 536 237. Le brevet cité décrit une entretoise pour plaques de circuits imprimés et servant à maintenir parallèle plusieurs plaques. L'entretoise comprend une embase supérieure munie d'un collet s'insérant dans un trou d'une plaque, une embase inférieure en vis-à-vis de la précédente, un élément longiligne entretoisant les deux embases. L'embase inférieure est munie d'un moyen d'accouplement élastique formé d'une butée élastique s'appuyant sur une des plaques et d'un crochet traversant ladite plaque pour se fixer sur l'embase supérieure d'une autre entretoise.

L'entretoise décrite dans le brevet cité a différents inconvénients comme par exemple de lier plusieurs plaques de circuits imprimés de façon rigide. Les circuits imprimés sont souvent soumis aux vibrations et aux chocs, un montage rigide entraine une destruction par cassure de la plaque de circuits. De plus, l'entretoise décrite ne permet pas un contact électrique entre deux plaques de circuits ou bien un lien thermique entre les plaques et le bâti support.

L'invention vise à fournir un support pour plaques de circuits imprimés assurant une élasticité entre le support et la plaque. Tout en étant peu encombrant, facile à monter, le support permet d'une part une conduction thermique entre les plaques, et aussi une liaison de deux circuits entre eux par un autre circuit rigide.

L'invention se caractérise en ce qu'entre l'embase et la plaque de circuits est inséré un amortisseur, la compression de l'amortisseur étant assurée par un organe d'accouplement mobile fixé d'une part sur le bord de la plaque et d'autre part sur une partie de la colonne. L'élasticité de l'amortisseur peut être ajustée en fonction de la fréquence des vibrations et de la masse mécanique de chacun des circuits, pour amortir les vibrations de la plaque de façon conséquente, lors du passage des fréquences critiques. Une précontrainte est assurée sur l'amortisseur par l'organe d'accouplement qui presse ledit amortisseur entre la plaque et l'embase.

Préférentiellement l'amortisseur est un tore de matière synthétique et plus particulièrement de silicone dont la dureté et la dimension sont calculées pour assurer la fonction d'amortissement reliée aux fréquences de vibrations critiques de la plaque.

Dans une forme préférentielle de l'invention, la colonne est munie de deux embases en vis-à-vis formant entretoise pour deux plaques de circuits.

Dans une telle structure un organe d'accouplement permet par symétrie, de précontraindre par pincements deux amortisseurs en vis-à-vis, tout en facilitant le montage de deux plaques de circuits et en assurant une bonne conduction thermique pour le refroidissement des plaques.

Particulièrement l'organe d'accouplement est une lame placée longitudinalement à la colonne et munie, à ses deux extrémités, d'une pince assujettie au bord de chacun des deux circuits, la lame étant en outre munie en son milieu d'un clip enserrant la partie médiane de la colonne.

L'organe d'accouplement est une tôle en acier à ressort découpée et liée pour former un clip liant par pincements d'une part les deux plaques de circuits, plaques qui compressent les amortisseurs et d'autre part la colonne du support.

Dans une autre forme de réalisation, l'organe d'accouplement est une bande munie de deux glissières longitudinales, bande placée perpendiculairement aux deux plaques, les glissières enserrant le bord de chacune des deux plaques la bande étant en outre munie à ses deux extrémités d'un élément élastique, les deux éléments élastiques enserrant par leur partie médiane deux colonnes contigus.

L'organe d'accouplement de grande surface est un radiateur thermique mais peut être aussi un lien rigide de connexion électrique placé entre les circuits respectifs des deux plaques.

La description ci-après, se référant aux dessins annexés, le tout donné à titre d'exemple non limitatif fera bien comprendre comment l'invention peut être réalisée.

La figure 1 présente un support pour deux plaques de circuits imprimés muni de deux embases.

La figure 2 montre le support de la figure 1 en vue éclatée.

La figure 3 montre le support de la figure 1 en vue éclatée et muni d'un organe d'accouplement formé d'une tôle découpée et pliée.

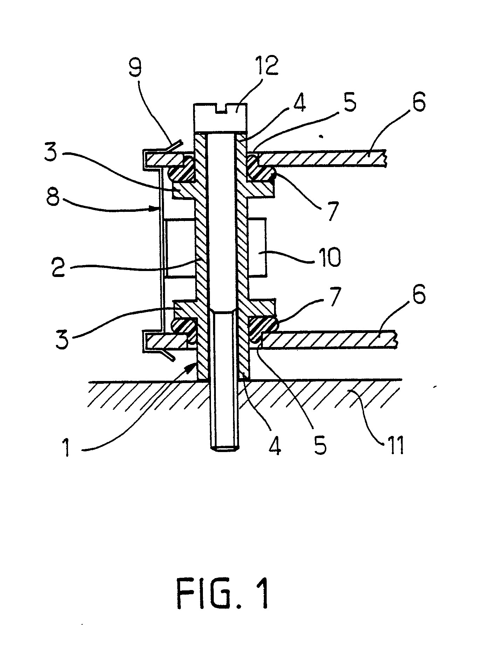

La figure 1 présente un support de plaques de circuits imprimés composé d'une colonne 1 formée d'un tube 2 et muni de deux embases 3 cylindriques en forme de collerette et placées près des deux extrémités du tube 2. Chaque extrémité du tube est alors un collet 4 qui se loge dans des trous 5 de centrage aménagés dans des plaques 6 de circuits imprimés.

Entre les plaques 6 et les embases 3 est inséré conformément à l'invention, un amortisseur 7, centré dans le collet 4 et monté en compression entre l'embase 3 et la plaque 6 de circuits. La compression est assurée par un organe d'accouplement 8 qui lie élastiquement d'une part, le circuit imprimé par une pince 9 qui se fixe sur le bord de la plaque 6 et d'autre part, une partie du tube 2 de la colonne 1 par un clip 10.

L'ensemble de la colonne 1 avec les deux plaques de circuits imprimés et l'organe d'accouplement, sont fixés sur un bâti 11 par une vis 12 qui traverse le tube 2, la tête de la vis s'appuyant sur la section du tube.

L'amortisseur est dans cet exemple de réalisation un joint en matière synthétique comme par exemple, une silicone, dont la dureté et les dimensions sont calculées en fonction de la masse respective de chaque plaque de circuits, et cela, pour assurer un amortissement aux vibrations de fréquences critiques auxquels sont soumis lesdits circuits et éviter ainsi les surtensions qui entraînent la cassure des plaques.

La colonne peut ne porter qu'un seul circuit, mais dans une forme plus pratique, la réalisation des embases 3 sont en vis-à-vis, comme les deux plaques de circuit, et cela afin d'utiliser un organe d'accouplement formé de deux pinces opposées assujetties chacune au bord d'une plaque.

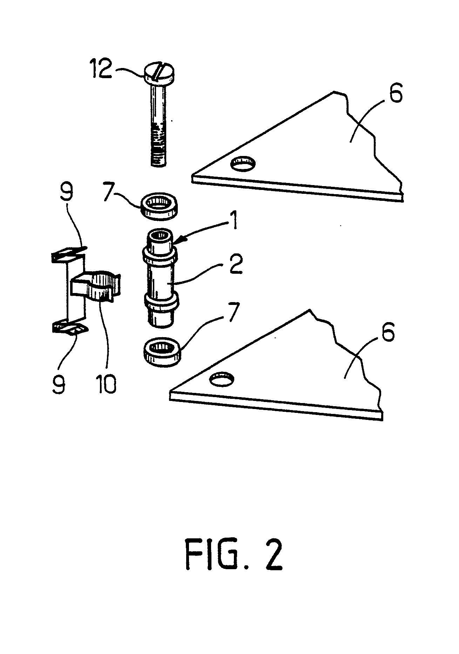

La figure 2 montre en vue éclatée le support de la figure 1. L'organe d'accouplement est formé d'une lame rectangulaire dont les extrémités sont pliées en pince plate 9.

La partie médiane de la lame, porte un clip 10 sensiblement en forme de U qui enserre une partie centrale cylindrique du tube 2 de la colonne 1. Le clip 10 peut être découpé et plié avec la lame en une seule pièce.

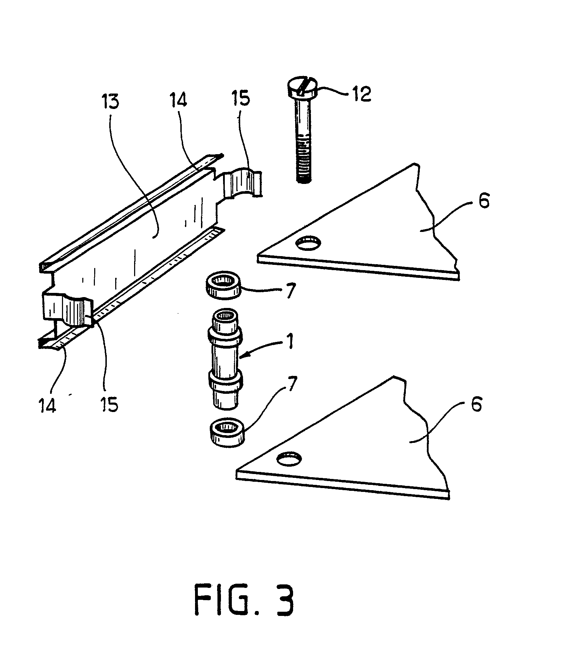

La figure 3 montre en vue éclatée le support muni d'un organe d'accouplement, formé d'une bande rectangulaire 13 sensiblement de même longueur qu'un bord de plaque 6, les bords longitudinaux de la bande 13 sont pliés pour former une glissière 14 qui pince le bord de la plaque sur sa longueur.

Les bords latéraux de la bande sont munis d'éléments élastiques, comme par exemple deux bras 15 qui enserrent respectivement deux colonnes 1 placées perpendiculairement aux plaques.

La bande 13 peut avoir en plus de la fonction de précompression des amortisseurs, la fonction de radiateur de refroidissement des plaques de circuits imprimés ou encore, une fonction de conduction électrique, les circuits des plaques pouvant alors être connectés entre eux.

**Revendications**

1. Support pour plaques de circuits imprimés formé d'une colonne comprenant au moins une embase sur laquelle vient en appui une plaque de circuit, un collet qui s'insère dans un trou de la plaque, et un organe d'accouplement, caractérisé en ce qu'entre l'embase et la plaque de circuits est inséré un amortisseur, la compression de l'amortisseur étant assurée par un organe d'accouplement mobile fixé d'une part sur le bord de la plaque et d'autre part sur une partie de la colonne.

2. Support pour plaques de circuits imprimés selon la revendication 1, caractérisé en ce que l'amortisseur est un tore de matière synthétique.

3. Support pour plaques de circuits imprimés selon l'une des revendications 1 et 2, caractérisé en ce que la colonne est munie de deux embases en vis-à-vis formant entretoise pour deux plaques de circuits.

4. Support pour plaques de circuits imprimés selon la revendication 3, caractérisé en ce que l'organe d'accouplement est une lame placée longitudinalement à la colonne et munie, à ses deux extrémités, d'une pince assujettie au bord de chacun des deux circuits, la lame étant en outre munie en son milieu d'un clip enserrant la partie médiane de la colonne.

5. Support pour plaques de circuits imprimés selon la revendication 3, caractérisé en ce que l'organe d'accouplement est une bande munie de deux glissières longitudinales, bande placée perpendiculairement aux deux plaques, les glissières enserrant le bord de chacune des deux plaques la bande étant en outre munie à ses deux extrémités d'un élément élastique, les deux éléments élastiques enserrant par leur partie médiane deux colonnes contigües.

FIG. 1

1-Ⅲ-PHF 87-533

FIG. 2

2 - III - PHF 87-533

# FIG. 3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 444 318 (ALEXANDER) <br> * Colonne 2, lignes 40-59 * <br> --- | 1,3-5 | H 05 K 7/14 |
| A | DE-A-3 531 958 (R. BOSCH) <br> * Colonne 3, lignes 29-33 * <br> --- | 1-2 | |
| A | DE-U-8 604 098 (ANT NACHRICHTENTECHNIK GmbH) <br> * Page 2, dernier alinéa * <br> --- | 1 | |
| A | GB-A-2 153 897 (KITAGAWA INDUSTRIES CO., LTD) <br> * Page 2, lignes 107-118 * <br> --- | 1 | |
| A,D | FR-A-2 536 237 (KITAGAWA INDUSTRIES CO., LTD) <br> * Page 4, lignes 23-35 * <br> ----- | 1 | |

**DOMAINES TECHNIQUES RECHERCHES (Int. Cl.4)**

H 05 K

Le présent rapport a été établi pour toutes les revendications

| Lieu de la recherche | Date d'achèvement de la recherche | Examinateur |
|---|---|---|
| LA HAYE | 07-08-1988 | TOUSSAINT F.M.A. |